# EUROPÄISCHE PATENTSCHRIFT

(11) **EP 3 370 494 B1**
(45) Veröffentlichungstag und Bekanntmachung des Hinweises auf die Patenterteilung: **19.07.2023**
(21) Anmeldenummer: 18158029.1
(22) Anmeldetag: 22.02.2018
(51) Int. Cl.: H05K 13/04

(54) **VORRICHTUNG ZUM BESTÜCKEN VON SUBSTRATEN MIT ELEKTRISCHEN BAUELEMENTEN**
DEVICE FOR POPULATING SUBSTRATES WITH ELECTRICAL COMPONENTS
DISPOSITIF DESTINÉ À ÉQUIPER DES SUBSTRATS AVEC DES COMPOSANTS ÉLECTRIQUES

(30) Priorität: 03.03.2017 DE 102017104475
(43) Veröffentlichungstag der Anmeldung: 05.09.2018
(73) Patentinhaber: Otto Künnecke GmbH, 37603 Holzminden (DE)
(72) Erfinder: Mehdianpour, Mohamed, 81829 München (DE)
(74) Vertreter: Müller Hoffmann & Partner

(56) Entgegenhaltungen:
- EP-A1- 2 848 107
- EP-A2- 2 747 537
- DE-C1- 10 016 130

## Beschreibung

Die Erfindung betrifft eine Vorrichtung zum Bestücken eines Substrates mit bereitstellbaren elektrischen Bauelementen gemäß dem Oberbegriff von Anspruch 1.

Die Erfindung bezieht sich insbesondere auf eine Vorrichtung zum Bestücken eines Substrats mit bereitstellbaren elektrischen Bauelementen mit mindestens einem Bestückkopf zum Handhaben der Bauelemente, wobei das Substrat in einer Längsrichtung durch die Vorrichtung transportierbar und in einem Bestückbereich der Vorrichtung fixierbar ist,
wobei die Bauelemente in zumindest einem Abholbereich der Vorrichtung breitstellbar sind, wobei der Bestückkopf zwischen dem Abholbereich und dem Bestückbereich verfahrbar ist, wobei ein sich in der Längsrichtung erstreckender Führungsarm an einem Grundkörper der Vorrichtung quer zur Längsrichtung verschiebbar gelagert ist, wobei der Führungsarm eine sich in der Längsrichtung erstreckende zwischen seinen Stirnenden durchgehende lineare erste Führungsbahn aufweist, in die dazu kompatible Linearlager des Bestückkopfs eingreifen,
wobei am Grundkörper zu beiden Seiten des Längenbereichs des Führungsarms zwei Führungselemente mit zu der ersten Führungsbahn kompatiblen zweiten Führungsbahnen gelagert sind, die sich außerhalb des Bestückbereichs in gleicher Höhenlage wie die Führungselemente parallel zur ersten Führungsbahn erstrecken,
wobei der Führungsarm in eine definierte Übergabeposition verschiebbar ist, in der die erste und zumindest eine der beiden zweiten Führungsbahnen miteinander fluchten,
wobei die jeweils einander zugewandten Enden der Führungsbahnen unmittelbar aneinander angrenzen und wobei der Bestückkopf über das Ende des Führungsarms hinaus auf die angrenzende zweite Führungsbahn verschiebbar ist.

Eine derartige Vorrichtung ist durch die DE102012009439 A1 bekannt geworden. Die Vorrichtung weist einen Bestückkopf zum Handhaben der Bauelemente auf, der in einer linearen Führungsbahn eines Führungsarms verschiebbar ist, der in einer Querrichtung an einem Grundkörper der Vorrichtung verschiebbar ist. Der Führungsarm ist in eine definierte Halteposition verschiebbar. In dieser ist in der Verlängerung der Führungsbahn mindestens ein im Wesentlichen stationäres Führungselement angebracht.

Der eine Vielzahl von Bauelementen aufnehmende Bestückkopf ist über das Ende des Führungsarms hinaus auf das Führungselement verschiebbar ist. In diesem zusätzlichen Verschiebebereich des Bestückkopfs und dem vom Führungsarm überdeckten Bereich und sind durchgehend Abholstellen für die Bauelemente angeordnet. Auf der gegenüberliegenden Längsseite der Vorrichtung sind weitere Abholstellen angeordnet, die mittels eines weiteren Führungsarms und eines weiteren Bestückkopfes erreicht werden, wobei jeweils ein Bestückkopf einem der Führungsarme zugeordnet ist.

Der Erfindung liegt die Aufgabe zugrunde, bei geringem baulichem Mehraufwand der Vorrichtung die Bestückleistung zu erhöhen.

Die Aufgabe wird durch eine Vorrichtung mit den Merkmalen von Anspruch 1 gelöst. Weiterbildungen sind den abhängigen Ansprüchen zu entnehmen.

Die Aufgabe wird insbesondere dadurch gelöst, dass in den Führungsbahnen ein weiterer, unabhängig von dem anderen Bestückkopf verschiebbarer Bestückkopf geführt ist und dass zumindest zeitweise einer der beiden Bestückköpfe ausschließlich an der ersten Führungsbahn und der andere ausschließlich an einer der zweiten Führungsbahnen gelagert ist.

Die ersten und zweiten Führungsbahnen bilden ein gemeinsames Führungssystem für die beiden Bestückköpfe, die weitgehend unabhängig voneinander agieren können. Es ist allgemein üblich, derartige Bestückköpfe so auszubilden, dass sie eine Vielzahl von Bauelementen aufnehmen können. Dadurch ist es z.B. möglich, einen der beiden Bestückköpfe auf einer der beiden stationären zweiten Führungsbahnen Bauelemente abholen zu lassen, während der andere mit dem Führungsarm über die Leiterplatte verfährt, um diese mit Bauelementen zu bestücken.

Danach wird der Führungsarm in die Übergabeposition verschoben, in der die Führungsbahnen miteinander fluchten. Der auf der stationären zweiten Führungsbahn befindliche Bestückkopf kann nun auf die mobile erste Führungsbahn des Führungsarms verschoben werden und auf dieser zugeordnete weitere Bauelemente abholen. Gleichzeitig kann der auf dem Führungsarm gelagerte Bestückkopf auf die gegenüberliegende zweite Führungsbahn verschoben werden und dort Bauelemente abholen. Durch die gleichzeitige Abhol- und Bestücktätigkeit der Bestückköpfe kann mit geringem baulichen Mehraufwand die Stückleistung der Vorrichtung erheblich gesteigert werden.

Die Führungselemente am Grundkörper sind in der Längsrichtung verschiebbar gelagert, wobei nach dem Entfernen des Führungsarms aus dem Bereich der Führungselemente diese in einen Überlappungsbereich mit der ersten Führungsbahn verschiebbar sind.

Die Verschiebbarkeit der Führungselemente in der Längsrichtung kann z.B. mittels üblicher Spindelantriebe und Linearführungen realisiert werden. Dadurch wird der dem jeweiligen Führungselement zugeordnete Abholbereich vom äußeren Ende bis zur Maschinenmitte erheblich vergrößert, so dass der Bestückkopf vollständig mit Bauelementen belegt werden kann, ohne noch Bauelemente vom Führungsarm aus abholen zu müssen. Die Abholtätigkeit und die Bestücktätigkeit können zeitlich gleichmäßig auf die beiden Bestückköpfe verteilt und deren Leistung entsprechend gesteigert werden. In Bezug auf die Übergabe des Bestückkopfs zwischen dem Führungsarm und den Führungselementen sind diese trotz ihrer Längsverschiebbarkeit als stationär zu verstehen.

In diesem Zusammenhang wird die erste Führungsbahn als mobile Führungsbahn verstanden, da sie zusammen mit dem Führungsarm beweglich, also mobil ist. Die beiden zweiten Führungsbahnen werden auch als stationäre Führungsbahnen verstanden, da sie zwar in Längsrichtung verschiebbar sind, aber dennoch als ortsfest bezeichnet werden können.

Die Führungselemente können über das äußere Ende des Grundkörpers hinaus verschiebbar sein.

Durch diese Weiterbildung kann der Abholbereich für die Bauelemente in der Längsrichtung verbreitert werden.

Die beiden zweiten Führungsbahnen beider Führungselemente können zueinander fluchtend angeordnet sein.

Durch die Weiterbildung ist es möglich, dass die beiden Führungselemente in die Maschinenmitte bis zum Zusammenstoßen bzw. bis zu einem Kontakt verschoben werden können und die Bestückköpfe auch unmittelbar von einem auf das andere Führungselement verfahren können.

Die Länge der beiden zweiten Führungsbahnen kann jeweils größer sein als die halbe Länge der ersten Führungsbahn, wobei die beiden Führungselemente wahlweise bis über die Mitte der ersten Führungsbahn verschiebbar sein können.

Durch diese Weiterbildung können die Bauelemente auch im Mittelbereich der Vorrichtung durchgehend aneinander gereiht und überlappend von beiden Führungselementen aus abgeholt werden. Insbesondere können in diesem Bereich häufig benötigte Bauelemente angeordnet und von beiden Bestückköpfen nacheinander abgeholt werden.

Die Bestückköpfe können an dem Führungsarm und an den Führungselementen jeweils mittels eines elektrischen Linearmotors verschiebbar sein, dessen Spulenteile an den Bestüccköpfen angebracht sind und dessen Magnetteile in gleichmäßiger Verteilung entlang dem Führungsarm und den Führungselementen angeordnet sind.

Durch diese Anordnung der Magnetteile wird erreicht, dass die Übergänge zwischen dem Führungsarm und den Führungselementen so gestaltet sind, als ob es sich um eine durchgehende Magnetbahn handeln würde, so dass das die elektrische Ansteuerung des Spulenteils unabhängig von der Position des Bestückkopfes in gleichbleibender Weise erfolgen kann.

Im Abholbereich können Abholstellen der Bauelemente entlang einer äußeren Längsseite der Vorrichtung in der Längsrichtung von einem, in Längsrichtung gesehen, äußeren Endbereich eines der in der Übergabeposition befindlichen Führungselemente durchgehend bis zu einem äußeren Endbereich des anderen Führungselementes aneinander gereiht sein.

Diese Weiterbildung ermöglicht die volle Ausnutzung des Abholbereichs der Bauelemente über die volle Maschinenlänge

Auf der dem Abholbereich in Querrichtung gegenüberliegenden Seite des Bestückbereichs kann ein zusätzlicher Abholbereich für die Bauelemente angeordnet sein.

Durch diese Weiterbildung wird die Anzahl der bereitstellbaren Bauelemente weiter gesteigert, wobei die zusätzlichen Abholstellen an einer zusätzlichen Seite vorzusehen sind. Die Bauelemente können nahe an der Leiterplatte angeordnet werden, so dass hier der Bestücckopf kürzere Fahrwege zurücklegen muss. Daher ist es von Vorteil, in diesem Bereich besonders häufig benötigte Bauelemente vorzusehen.

Es können Führungsmittel für den Führungsarm, der Führungsarm, die Bestückköpfe, die Führungselemente und der Abholbereich auf der dem Bestückbereich gegenüberliegenden Seite der Vorrichtung drehsymmetrisch gedoppelt sein. Dadurch können die Bestückleistung und Anzahl der Abholstellen für die Bauelemente weiter gesteigert werden.

Ausführungsbeispiele der Erfindung sind in der Zeichnung dargestellt und werden im Folgenden näher erläutert. Es zeigen:
- Figur 1: eine perspektivische Ansicht einer Vorrichtung zum Bestücken von Substraten mit elektrischen Bauelementen,
- Figur 2: eine Draufsicht auf die Vorrichtung nach Figur 1 in einem anderem Betriebsstadium, und
- Figur 3: eine Draufsicht auf die Vorrichtung nach Figur 1 in einem weiteren Betriebsstadium.

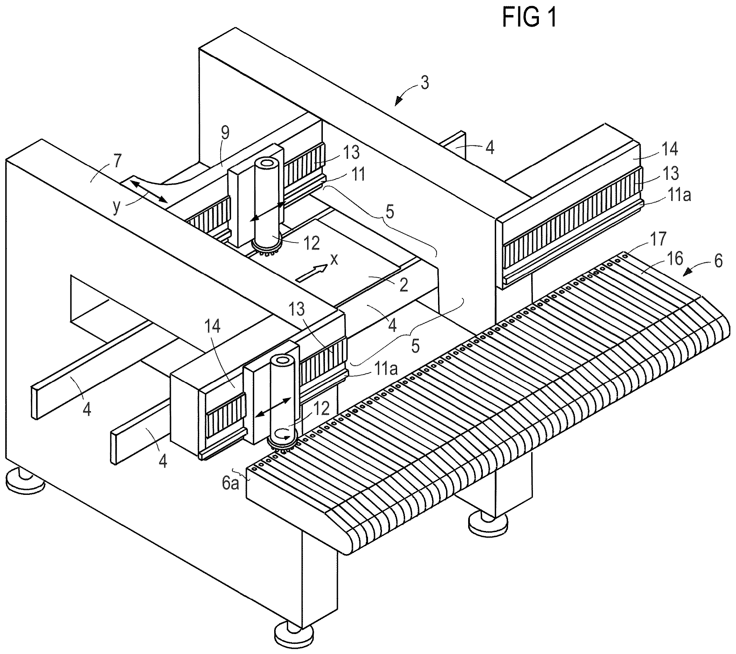

Nach den Figuren 1, 2 und 3 weist eine Vorrichtung zum Bestücken von Substraten 2 mit elektrischen Bauelementen einen Grundkörper 3 auf, an dem eine waagerechte lineare Transportstrecke 4 für die Substrate 2 angebracht ist, die gemäß dem gezeigten Richtungspfeil x (Längsrichtung) durch die Vorrichtung verschiebbar sind und die in einem Bestückbereich 5 der Vorrichtung auf der Transportstrecke 4 in der gezeigten Position fixierbar sind. Die Transportrichtung der Transportstrecke 4 stellt eine Längsrichtung x der Vorrichtung dar. Die Bauelemente sind von einem Abholbereich 6a einer Bereitstelleinrichtung 6 abholbar, die in nicht näher dargestellter Weise an den Grundkörper 3 angedockt ist.

Der Grundkörper 3 weist zu beiden Seiten des Bestückbereichs 5 sich quer zur Längsrichtung x erstreckende, nach oben ragende Seitenwände 7 auf. Eine von diesen ist auf einer der einander zugewandten Innenseiten mit linearen Führungsmitteln 8 und nicht dargestellten Antriebsmitteln für einen sich im Wesentlichen in der Längsrichtung x erstreckenden Führungsarm 9 versehen, der somit in einer waagerechten Querrichtung y senkrecht zur Längsrichtung x verschiebbar ist.

Der Führungsarm 9 weist auf seiner der Transportstrecke 4 abgewandten flachen Außenseite eine schienenartige lineare erste Führungsbahn 11 für einen in der Längsrichtung waagerecht verschiebbaren Bestückkopf 12 zum Handhaben der Bauelemente auf. Der Verschiebeweg des Führungsarms 9 in der Querrichtung y ist so groß, dass der Bestückkopf 12 zwischen dem Bestückbereich 5 und einer der Bereitstelleinrichtungen 6 verfahrbar ist, die nahe dem Endbereich dieses (Quer-)Verschiebewegs angeordnet ist.

Der Bestückkopf 12 ist mittels eines elektrische Linearmotors verschiebbar, dessen Magnetteile 13 in der Längsrichtung x am Führungsarm 9 aneinander gereiht sind und dessen Spulenteil dem Bestückkopf 12 zugeordnet ist. Dieser ist in nicht näher dargestellter Weise mit mehreren zueinander parallelen, zylindrisch verteilten, in sich drehbaren Haltern zum Aufnehmen und Absetzen der Bauelemente versehen. Die Halter sind in senkrechter Richtung verschiebbar in einem Rotor gelagert sind, der um eine senkrechte Mittelachse drehbar ist.

An den einander abgewandten Außenseiten der Seitenwände 7 sind in der Längsrichtung x ragende Trägerteile 3a des Grundkörpers 3 auf der der Bereitstelleinrichtung 6 zugewandten Längsseite der Vorrichtung angesetzt. An den Trägerteilen 3a sind plattenartige Führungselemente 14 gelagert, an denen zweite Führungsbahnen 11a ausgebildet sind, deren Führungsprofil mit der ersten Führungsbahn 11 deckungsgleich ist und die sich in der gleichen Höhenlage parallel zur ersten Führungsbahn 11 erstrecken.

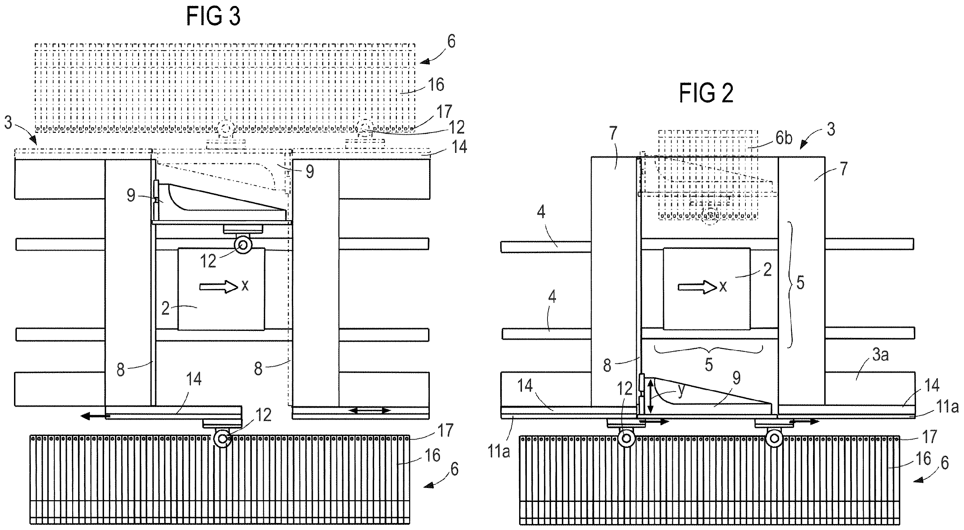

Der Führungsarm 9 kann in eine in Figur 2 dargestellte Übergabeposition verschoben werden, in der die unmittelbar aneinandergrenzenden ersten und zweiten Führungsbahnen 11 und 11a zueinander fluchten. Die Reihe der Magnetteile 13 setzt sich in gleichbleibender Teilung ebenfalls auf den Führungselementen 14 fort. Dadurch kann der Bestückkopf 12 nicht nur auf dem Führungsarm 9, sondern auch auf die Führungselemente 14 verschoben werden, wodurch sich sein Verschiebeweg entsprechend verlängert.

Die Bereitstelleinrichtung 6 ist mit flachen, senkrecht stehenden Zuführmodulen 16 versehen, die in der Längsrichtung x aneinander gereiht sind. Die Zuführmodule 16 können mit in Gurtspulen gespeicherten Bauelementen versehen werden, die zu Abholstellen 17 auf der Oberseite der Zuführmodule 16 transportiert werden, wo sie vom Bestückkopf 12 entnommen werden können. Die in der Längsrichtung aneinander gereihten Abholstellen 17 befinden sich in den dem Führungsarm 9 zugewandten Endabschnitten der Zuführmodule 16 im Zugriffsbereich der Halter des Bestückkopfs 12, der sowohl an den Führungselementen 14 als auch an dem in der Übergabeposition befindlichen Führungsarm 9 gelagert sein kann. Die Bereitstelleinrichtung 6 ist so lang, dass sich die Reihe der Zuführmodule 16 bis in den Endbereich der Führungselemente 14 erstreckt, so dass auch die äußersten Abholstellen 17 im Zugriffsbereich des Bestückkopfes 12 liegen, der bis an das freie Ende des jeweiligen Führungselementes 14 verschoben werden kann.

Der nach Figur 1 am Führungsarm 9 gelagerte Bestückkopf 12 befindet sich im Bestückbereich 5 der Vorrichtung und setzt die an den Haltern haftenden Bauelemente an den vorgesehenen Stellen auf das Substrat 2 auf.

Ein mit dem Bestückkopf 12 baugleicher weiterer Bestückkopf 12 befindet sich auf einem der Führungselemente 14 und nimmt die dort erreichbaren Bauelemente mit seinen Haltern auf. Nach dem Absetzen der Bauelemente auf das Substrat 2 verfährt der Führungsarm 9 in die in Figur 2 dargestellte Übergabeposition, in der der Bestückkopf 12 auf das freie Führungselement 14 und der weitere Bestückkopf 12 auf den Führungsarm 9 bis in dessen Mittelbereich verfährt und dabei von den Abholstellen 17 weitere Bauelemente abholt. Worauf der Führungsarm 9 mit dem weiteren Bestückkopf 12 zur nachfolgenden Bestückung über das Substrat 2 verfährt. Dieser Zyklus wiederholt sich mit den vertauschten Bestückköpfen 12 und vertauschten Führungselementen 14, wobei jeder der beiden Bestückköpfe 12 immer nur auf eines der Führungselemente14 gelangen kann.

In Fig. 2 ist auf der den Abholstellen 17 gegenüberliegenden Seite der Transportstrecke 4 eine weitere Bereitstelleinrichtung 6b strichpunktiert angedeutet, deren Abholstellen 17 von dem am Führungsarm 9 gelagerten Bestückkopf 12 erreicht werden können. Dadurch kann die Anzahl der bereitgestellten verschiedenen Bauelemente weiter erhöht werden. Ferner kann die weitere Bereitstelleinrichtung 6b so schmal ausgebildet sein, dass sie zwischen die Seitenwände 7 passt und nahe an dem Bestückbereich 5 angeordnet werden kann, so dass sich die vom Bestückkopf 12 zurückgelegten Wege verkürzen.

Nach Figur 3 kann sind die Führungselemente 14 am Grundkörper 3 in der Längsrichtung x verschiebbar gelagert. Eines von ihnen (in Figur 3 links) ist aus der äußeren Endlage bis über die Mitte des gesamten Abholbereichs verschoben, so dass der darauf verschiebbare Bestückkopf 12 auch die - in Längsrichtung x gesehen - mittleren Abholstellen 17 erreichen kann.

Der Führungsarm 9 mit dem anderen Bestückkopf 12 kann zugleich ungehindert das Substrat 2 bestücken, während das andere Führungselement 14 (in Figur 3 rechts) passiv in seiner äußeren Endlage verbleibt.

Nach dem Abholen von Bauelementen aus dem inneren Abholbereich kann das Führungselement 14 in seine äußere Endlage verfahren werden und dort weitere Bauelemente abholen. Nach Beendigung der Bestückvorgänge wird der Führungsarm 9 in die Übergabeposition verfahren. Der betreffende Bestückkopf 12 verfährt nun auf das zuvor passive Führungselement 14 und der an dem zuvor aktiven Führungselement 14 gelagerte Bestückkopf 12 auf den Führungsarm 9, worauf sich die zuvor beschriebenen Vorgänge mit den vertauschten Bestückköpfen 12 und Führungselementen 14 wiederholen.

Wie strichpunktiert angedeutet, können der Führungsarm 9, die Führungsmittel 8, die Trägerteile 3a, die Führungselemente 14, die Bestückköpfe 12 und die Bereitstelleinrichtung 6 um die Mitte der Vorrichtung drehsymmetrisch gedoppelt sein, wodurch sich die Anzahl der Zuführmodule 16 und die Bestückleistung entsprechend erhöht. Durch diese Doppelung werden auf beiden Längsseiten der Vorrichtung Bauelemente bereitgestellt. Durch die gedoppelten Bestückköpfe wird die Bestückleistung weiter gesteigert.

### Bezugszeichen

- 2: Substrat
- 3: Grundkörper
- 3a: Trägerteil
- 4: Transportstrecke
- 5: Bestückbereich
- 6: Bereitstelleinrichtung
- 7: Seitenwand
- 8: Führungsmittel
- 9: Führungsarm
- 11: Längsführung
- 12: Bestückkopf
- 13: Magnetteil
- 14: Führungselement
- 16: Zuführmodul
- 17: Abholstelle

## Patentansprüche

1. Vorrichtung zum Bestücken eines Substrats (2) mit bereitstellbaren elektrischen Bauelementen, mit
- einem Grundkörper (3), und mit
- mindestens einem Bestückkopf (12) zum Handhaben der Bauelemente, wobei
- das Substrat (2) in einer Längsrichtung (x) durch die Vorrichtung transportierbar und in einem Bestückbereich (5) der Vorrichtung fixierbar ist,
- die Bauelemente in zumindest einem Abholbereich (6a) der Vorrichtung breitstellbar sind,
- der Bestückkopf (12) zwischen dem Abholbereich (6a) und dem Bestückbereich (5) verfahrbar ist,
- ein sich in der Längsrichtung (x) erstreckender Führungsarm (9) an dem Grundkörper (3) quer zur Längsrichtung (x) verschiebbar gelagert ist,
- der Führungsarm (9) eine sich in der Längsrichtung (x) erstreckende, zwischen seinen Stirnenden durchgehende lineare erste Führungsbahn (11) aufweist, in die dazu kompatible Linearlager des Bestückkopfs (12) eingreifen,
- an dem Grundkörper (3) zu beiden Seiten des Längenbereichs des Führungsarms (9) zwei Führungselemente (14) mit zu der ersten Führungsbahn (11) kompatiblen zweiten Führungsbahnen (11a) gelagert sind, die sich außerhalb des Bestückbereichs (5) in gleicher Höhenlage wie die erste Führungsbahn (11) des Führungselements (14) parallel zur ersten Führungsbahn (11) erstrecken,
- der Führungsarm (9) in eine definierte Übergabeposition verschiebbar ist, in der die erste Führungsbahn (11) und die beiden zweiten Führungsbahnen (11a) miteinander fluchten,
- die jeweils einander zugewandten Enden der ersten und zweiten Führungsbahnen (11, 11a) unmittelbar aneinander angrenzen, und wobei
- der Bestückkopf (12) über das Ende des Führungsarms (9) hinaus auf die angrenzende zweite Führungsbahn (11a) verschiebbar ist, wobei
- in den Führungsbahnen (11, 11a) ein unabhängig von dem anderen Bestückkopf (12) verschiebbarer weiterer Bestückkopf (12) geführt ist,
- ein Betriebszustand möglich ist, in dem zumindest zeitweise einer der beiden Bestückköpfe (12) ausschließlich an der ersten Führungsbahn (11) und der andere ausschließlich an einer der zweiten Führungsbahnen (11a) gelagert ist, und wobei in einem anderen Betriebszustand, in dem der Führungsarm in der Übergabeposition ist, der auf der zweiten Führungsbahn (11a) befindliche Bestückkopf (12) auf die erste Führungsbahn (11) des Führungsarms verschoben werden kann und gleichzeitig der auf dem Führungsarm gelagerte Bestückkopf auf die gegenüberliegende zweite Führungsbahn verschoben werden kann;
- die Führungselemente (14) am Grundkörper (3) in der Längsrichtung (x) verschiebbar gelagert sind, und
- nach dem Entfernen des Führungsarms (9) aus dem Bereich der Führungselemente (14) diese in einen Überlappungsbereich mit der ersten Führungsbahn (11) verschiebbar sind.

2. Vorrichtung nach Anspruch 1, **dadurch gekennzeichnet, dass**
die Führungselemente (14) über das äußere Ende des Grundkörpers (3) hinaus verschiebbar sind.

3. Vorrichtung nach Anspruch 1 oder 2, **dadurch gekennzeichnet, dass** die beiden zweiten Führungsbahnen (11a) beider Führungselemente (14) zueinander fluchtend angeordnet sind.

4. Vorrichtung nach einem der Ansprüche 1 bis 3, **dadurch gekennzeichnet, dass**
- die Länge der beiden zweiten Führungsbahnen (11a) jeweils größer ist als die halbe Länge der ersten Führungsbahn (11), und dass
- die beiden Führungselemente (14) wahlweise bis über die Mitte der ersten Führungsbahn (11) verschiebbar sind.

5. Vorrichtung nach einem der vorhergehenden Ansprüche, **dadurch gekennzeichnet, dass** die Bestückköpfe (12) an dem Führungsarm (9) und an den Führungselementen (14) jeweils mittels eines elektrischen Linearmotors verschiebbar sind, dessen Spulenteile an den Bestückköpfen (12) angebracht sind und dessen Magnetteile (13) in gleichmäßiger Verteilung entlang dem Führungsarm (9) und den Führungselementen (14) angeordnet sind.

6. Vorrichtung nach einem der vorhergehenden Ansprüche, **dadurch gekennzeichnet, dass** im Abholbereich (6a) Abholstellen (17) der Bauelemente entlang einer äußeren Längsseite der Vorrichtung in der Längsrichtung (x) von einem, in Längsrichtung (x) gesehen, äußeren Endbereich eines der in der Übergabeposition befindlichen Führungselemente (14) durchgehend bis zu einem äußeren Endbereich des anderen Führungselementes (14) aneinander gereiht sind.

7. Vorrichtung nach einem der vorhergehenden Ansprüche, **dadurch gekennzeichnet, dass** auf der dem Abholbereich (6a) in Querrichtung (y) gegenüberliegenden Seite des Bestückbereichs (5) ein zusätzlicher Abholbereich (6b) für die Bauelemente angeordnet sind.

8. Vorrichtung nach Anspruch 7, **dadurch gekennzeichnet,**
**dass** Führungsmittel (8) für den Führungsarm (9), der Führungsarm (9), die Bestückköpfe (12), die Führungselemente (14) und der Abholbereich 6a auf der dem Bestückbereich (5) gegenüberliegenden Seite der Vorrichtung drehsymmetrisch gedoppelt sind.

## Claims

1. Device for fitting a substrate (2) with electrical components which can be provided, with
- a base plate (3), and with
- at least one fitting head (12) for manipulating the components,
wherein
- the substrate (2) can be transported in longitudinal direction (x) by the device, and can be fixed in a fitting region (5) of the device,
- the components can be provided in at least one collection region (6a) of the device,
- the fitting head (12) can be displaced between the collection region (6a) and the fitting region (5),
- a guide arm (9) extending in longitudinal direction (x) is displaceably housed, transverse to the longitudinal direction (x), on the base plate (3),
- the guide arm (9) has a linear first guide track (11) extending in longitudinal direction (x) passing between its end faces, in which track linear bearings of the fitting head (12), compatible therewith, engage,
- two guide elements (14) with second guide tracks (11a) compatible with the first guide track (11) are housed on both sides of the longitudinal region of the guide arm (9) at the base plate (3), which elements extend parallel to the first guide track (11) outside of the fitting region (5) at the same height as the first guide track (11) of the guide element (14),
- the guide arm (9) can be displaced in a defined hand-over position in which the first guide track (11) and the two second guide tracks (11a) are flush to one another,
- each of which directly adjoin ends of the first and second guide tracks (11, 11a) facing one another, and wherein
- the fitting head (12) can be displaced over the end of the guide arm (9) onto the adjoining second guide track (11a), wherein
- a further fitting head (12), which can be displaced independently of the other fitting head (12), is guided into the guide tracks (11, 11a),
- an operating state is possible in which at least occasionally one of the two fitting heads (12) is housed exclusively on the first guide track (11) and the other is housed exclusively on one of the second guide tracks (11a), and wherein in another operating state, in which the guide arm is in the hand-over position, the fitting head (12) located on the second guide track (11a) can be shifted onto the first guide track (11) of the guide arm and simultaneously the fitting head housed on the guide arm can be shifted onto the opposing second guide track;
- the guide elements (14) are displaceably housed in the longitudinal direction (x) at the base plate (3), and
- after removing the guide arm (9) from the region of the guide elements (14), these are shifted into an overlap region with the first guide track (11).

2. Device according to claim 1, **characterised in that** the guide elements (14) can be shifted over the outer end of the base plate (3).

3. Device according to claim 1 or 2, **characterised in that** the two second guide tracks (11a) of both guide elements (14) are arranged flush to one another.

4. Device according to one of claims 1 to 3, **characterised in that**
- the length of each of the two second guide tracks (11a) is greater than half the length of the first guide track (11), and that
- the two guide elements (14) can optionally be shifted as far as the centre of the first guide track (11).

5. Device according to one of the preceding claims, **characterised in that** the fitting heads (12) can each be displaced on the guide arm (9) and on the guide elements (14) by means of an electric linear motor, the coil parts of which are attached to the fitting heads (12) and the magnetic parts of which (13) are arranged in uniform distribution along the guide arm (9) and the guide elements (14).

6. Device according to one of the preceding claims, **characterised in that**, in the collection region (6a), collection points (17) of the components are linked along an outer longitudinal side of the device, from an outer end region of one of the guide elements (14) located in the hand-over position, viewed in longitudinal direction (x), as far as an outer end region of the other guide element (14).

7. Device according to one of the preceding claims, **characterised in that** an additional collection region (6b) is arranged for the components on the side of the fitting region (5) opposite the collection region (6a) in transverse direction (y).

8. Device according to claim 7, **characterised in that** guide means (8) for the guide arm (9), the guide arm (9), the fitting heads (12), the guide elements (14) and the collection region 6a are duplicated, in rotationally-symmetrical manner, on the side of the device opposite the fitting region (5).

## Revendications

1. Dispositif pour équiper un substrat (2) d'éléments structurels électriques pouvant être mis à disposition, comprenant
- un corps de base (3), et comprenant
- au moins une tête d'équipement (12) pour la manipulation des éléments structurels,
dans lequel
- le substrat (2) peut être transporté dans une direction longitudinale (x) par le dispositif et peut être fixé dans une zone d'équipement (5) du dispositif,
- les éléments structurels peuvent être mis à disposition dans au moins une zone d'enlèvement (6a) du dispositif,
- la tête d'équipement (12) est déplaçable entre la zone d'enlèvement (6a) et la zone d'équipement (5),
- un bras de guidage (9) s'étendant dans la direction longitudinale (x) est supporté de manière coulissante sur le corps de base (3) transversalement à la direction longitudinale (x),
- le bras de guidage (9) présente un premier chemin de guidage (11) linéaire continu entre ses extrémités frontales s'étendant dans la direction longitudinale (x) dans lequel s'engagent des paliers linéaires compatibles avec celui-ci de la tête d'équipement (12),
- deux éléments de guidage (14) comprenant de seconds chemins de guidage (11a) compatibles avec le premier chemin de guidage (11) sont supportés sur le corps de base (3) des deux côtés de la zone longitudinale du bras de guidage (9), lesquels s'étendent en dehors de la zone d'équipement (5) dans la même position verticale que le premier chemin de guidage (11) de l'élément de guidage (14) parallèlement au premier chemin de guidage (11),
- le bras de guidage (9) est coulissant dans une position de remise définie, dans laquelle le premier chemin de guidage (11) et les deux seconds chemins de guidage (11a) s'alignent l'un sur les autres,
- les extrémités tournées respectivement l'une vers l'autre des premier et seconds chemins de guidage (11, 11a) sont directement contiguës l'une à l'autre, et dans lequel
- la tête d'équipement (12) est coulissante au-delà de l'extrémité du bras de guidage (9) sur le second chemin de guidage (11a) contigu, dans lequel
- une autre tête d'équipement (12) coulissante indépendamment de l'autre tête d'équipement (12) est guidée dans les chemins de guidage (11, 11a),
- un état de fonctionnement est possible dans lequel, au moins temporairement, une des deux têtes d'équipement (12) est exclusivement supportée sur le premier chemin de guidage (11) et l'autre exclusivement sur un des seconds chemins de guidage (11a), et dans lequel, dans un autre état de fonctionnement, dans lequel le bras de guidage est dans la position de remise, la tête d'équipement (12) se trouvant sur le second chemin de guidage (11a) peut être déplacée sur le premier chemin de guidage (11) du bras de guidage et simultanément, la tête d'équipement supportée sur le bras de guidage peut être déplacée sur le second chemin de guidage opposé ;
- les éléments de guidage (14) sont supportés de manière coulissante dans la direction longitudinale (x) sur le corps de base (3), et
- après le retrait du bras de guidage (9) hors de la zone des éléments de guidage (14), ceux-ci sont coulissants dans une zone de recouvrement avec le premier chemin de guidage (11).

2. Dispositif selon la revendication 1, **caractérisé en ce que**
les éléments de guidage (14) sont coulissants au-delà de l'extrémité extérieure du corps de base (3).

3. Dispositif selon la revendication 1 ou 2, **caractérisé en ce que**
les deux chemins de guidage (11a) des deux éléments de guidage (14) sont agencés de manière alignée l'un sur l'autre.

4. Dispositif selon l'une des revendications 1 à 3, **caractérisé en ce que**
- la longueur des deux seconds chemins de guidage (11a) est à chaque fois supérieure à la demi-longueur du premier chemin de guidage (11), et que
- les deux éléments de guidage (14) sont coulissants sélectivement jusqu'au-dessus du milieu du premier chemin de guidage (11).

5. Dispositif selon l'une des revendications précédentes, **caractérisé en ce que** les têtes d'équipement (12) sont coulissantes sur les bras de guidage (9) et sur des éléments de guidage (14) à chaque fois au moyen d'un moteur linéaire électrique dont les parties de bobine sont montées sur des têtes d'équipement (12) et dont les parties magnétiques (13) sont agencées en répartition uniforme le long du bras de guidage (9) et des éléments de guidage (14).

6. Dispositif selon l'une des revendications précédentes, **caractérisé en ce que** dans la zone d'enlèvement (6a), des points d'enlèvement (17) des éléments structurels sont juxtaposés les uns aux autres le long d'un côté longitudinal extérieur du dispositif dans la direction longitudinale (x) d'une zone d'extrémité extérieure, vue dans la direction longitudinale (x) d'un des éléments de guidage (14) se trouvant dans la position de remise en continu jusqu'à une zone d'extrémité extérieure de l'autre élément de guidage (14).

7. Dispositif selon l'une des revendications précédentes, **caractérisé en ce qu'**une zone d'enlèvement (6b) supplémentaire pour les éléments structurels est agencée du côté opposé à la zone d'enlèvement (6a) dans la direction transversale (y) de la zone d'équipement (5) .

8. Dispositif selon la revendication 7, **caractérisé en ce que**
des moyens de guidage (8) pour le bras de guidage (9), le bras de guidage (9), les têtes d'équipement (12), les éléments de guidage (14) et la zone d'enlèvement (6a) sont doublés de manière symétrique en rotation sur le côté opposé à la zone d'équipement (5) du dispositif.
